# EUROPEAN PATENT SPECIFICATION

(11) **EP 0 678 973 B1**
(45) Date of publication and mention of the grant of the patent: **17.01.2001**
(21) Application number: 95105773.6
(22) Date of filing: 18.04.1995
(51) Int. Cl.: H03D 7/16, H03B 5/32

(54) **Receiving circuit for generating intermediate frequency signal having frequency characteristics independent of variations in temperature**
Empfängerschaltung zur Generierung von Zwischenfrequenzsignalen mit einer temperaturschwankungsunabhängigen Frequenzcharakteristik
Circuit récepteur pour générer un signal de fréquence intermédiaire ayant des caractéristiques de fréquence indépendantes des variations de température

(30) Priority: 18.04.1994 JP 7903194
(43) Date of publication of application: 25.10.1995
(73) Proprietor: NEC Corporation, Minato-ku, Tokyo 108-8001 (JP)
(72) Inventor: Fukiharu, Eiichi, Tokyo (JP)
(74) Representative: VOSSIUS & PARTNER

(56) References cited:
- EP-A- 0 386 498
- EP-A- 0 466 084
- US-A- 3 787 612
- PATENT ABSTRACTS OF JAPAN vol. 16 no. 112 (E-1180) ,19 March 1992 & JP-A-03 284008 (KYOCERA CORP.) 13 December 1991,

## Description

The present invention relates to a receiving circuit, and more particularly to a receiving circuit for generating an intermediate frequency signal having frequency characteristics independent of a variation in the temperature.

When the ambient temperature varies, filter characteristics of a filter included in a receiving circuit also change. Accordingly, there occurs a problem such that the filter cuts off any frequency of an input signal which must not be essentially cut off.

JP-A-59-133737 discloses an intermediate frequency block which can solve the above described problem. In this intermediate frequency block, a local oscillating circuit for outputting a local signal is connected to a surface acoustic wave resonator. A tuner portion receives a local signal and a received signal and outputs an intermediate frequency signal. A Nyquist filter filters the intermediate frequency signal.

Since the surface acoustic wave resonator and the Nyquist filter are formed on the same piezoelectric substrate in this intermediate frequency block, even When the filter characteristics of the Nyquist filter vary due to a change in the ambient temperature, the resonator characteristics of the surface acoustic wave resonator follow the variation in the filter characteristic. Further, the frequency characteristics of the local signal vary in accordance with a change in the resonator characteristics of the surface acoustic wave resonator. Since the frequency characteristics of the intermediate frequency signal vary in response to a change in the filter characteristics of the Nyquist filter, there occurs no cut-off of frequency, which must not be essentially cut off, of the intermediate frequency signal.

In such an intermediate frequency block, however, since the intermediate frequency signal is detected after the compensation of the frequency characteristics variation due to a change in the temperature, the center frequency of the intermediate frequency signal remains to be shifted by the amount of the temperature deviation.

On the other hand, in view of the above-described problem, JP-A-3-284008 discloses a receiving circuit employing a surface acoustic wave apparatus with which the frequency characteristics of the intermediate frequency signal to be supplied to a demodulator do not vary even when the ambient temperature changes.

This receiving circuit adopts a superheterodyne receiving method. A first frequency mixer receives a received signal and a first local signal from a voltage controlled oscillating circuit and generates a first intermediate frequency signal. An intermediate frequency filter is constituted by a surface acoustic wave filter and formed on the same piezoelectric substrate together with a surface acoustic wave resonator. The intermediate frequency filter filters the first intermediate frequency signal. A second local oscillating circuit is connected to the surface acoustic wave resonator and outputs a second local signal. A second frequency converter receives a filtered first intermediate frequency signal and the second local signal and produces a second intermediate frequency signal. A microprocessor is connected to the voltage controlled oscillating circuit via a phase synchronous circuit and controls the frequency characteristics of the first local signal in response to changes in the ambient temperature.

In this receiving circuit, since the microprocessor controls the frequency characteristics of the first local signal in response to changes in the ambient temperature, the frequency characteristics of the first local signal output from the voltage controlled oscillating circuit vary equally with the changes of the filter characteristics of the surface acoustic wave filter. Even when the filter characteristics of the surface acoustic wave filter vary, the frequency characteristics of the first local signal therefore change in response to a variation in the filter characteristics. The frequency characteristics of the first intermediate frequency signals thus follow the filter characteristics of the surface acoustic wave filter, and any first intermediate frequency, which must not be essentially cut off, of the first intermediate frequency signals can not be cut off.

Further, since the surface acoustic wave resonator connected to the second local oscillating circuit and the surface acoustic wave filter constituting the intermediate frequency filter are formed on the same piezoelectric substrate in this receiving circuit, even when the frequency characteristics of the filtered first intermediate frequency signal output from the surface acoustic wave filter and the filter characteristics of the surface acoustic wave filter vary, the variations in both the characteristics can be offset by each other. In this receiving circuit, therefore, the variation in the resonator characteristics of the surface acoustic wave resonator involves the change in the frequency characteristics of the second local signal. The second frequency converter suppresses the variation in the frequency characteristics of the first intermediate frequency signal by using the change in the frequency pharacteristics of the second local signal. In such a manner, the change in the frequency characteristics of the second intermediate frequency signal can not be caused.

In this receiving circuit, however, there occurs a problem such that receiving circuit becomes expensive because of use of the microprocessor.

EP-A-446 084 discloses an SAW electric part and frequency conversion circuit. The SAW electric part includes an SAW filter and an SAW resonator formed on a substrate having the same temperature characteristics as those of a substrate on which the SAW filter is formed. A frequency converter includes the SAW electric part, a second local oscillation circuit, a frequency converter, a first mixer, and a second mixer. The second local oscillation circuit oscillates a second local oscillation signal using the SAW resonator. The frequency converter converts a frequency of the second local oscillation signal to generate a first local oscillation signal. The first mixer mixes the first local oscillation signal with an input signal to output a composite signal to the SAW filter. The second mixer mixes an output from the SAW filter with the second local oscillation signal to output a frequency conversion signal.

EP-A-386 498 discloses an oscillator in which the shape and position of each chip and wiring between the chips are optimally designed. An SAW element and an IC are arranged in the same package, the oscillator is not greatly influenced by external electromagnetic induction and is not unstably oscillated.

It is therefore an object of the present invention to provide a receiving circuit for generating intermediate frequency signal having frequency characteristics independent of variations in temperature, which is capable of reducing the price of the receiving circuit. This object is achieved with the features of the claims.

The receiving circuit as described includes a resonator, an oscillating means which is connected to the resonator and outputs a first oscillation frequency signal, and a first local oscillating circuit for outputting a first local signal from the first local oscillation frequency signal. A first frequency converting means generates a first intermediate frequency signal having a frequency determined by a frequency of the first oscillation frequency signal from a received signal and the first local signal. A filter means has the temperature characteristics similar to those of the resonator and filters the first intermediate frequency. A second frequency converting means generates a second intermediate frequency signal having the frequency characteristics which do not depend on a frequency variations of the first oscillation frequency signal from an output signal from the filter means and the first oscillation frequency signal.

According to the present invention adopting the above-described arrangement, the resonator characteristics of the resonator in which the ambient temperature varies change, the frequency characteristics of the first oscillation frequency signal vary, and the frequency characteristics of the first local signal change. Since the first frequency converting means receives the first local signal and generates the first intermediate frequency signal having a frequency determined by a frequency of the first oscillation frequency signal, the frequency characteristics of the first intermediate frequency signal vary. Meanwhile, since the filter means has the temperature characteristics which are similar to those of the resonator, the frequency among frequencies of the first intermediate frequency signal which must not be essentially cut off can not be cut off, filtering the first intermediate frequency. The second frequency converting means produces the second intermediate frequency signal using a second local signal having a frequency which does not depend on the frequency variations of the first oscillation frequency signal and on the output signal of the filter means. The present invention can therefore generate the second intermediate frequency signal having a desired frequency irrespective of a change in the ambient temperature without using a microprocessor, thereby reducing the price of the receiving circuit.

These and other objects, features and advantages of the invention will become more fully apparent from the following detailed description taken in conjunction with the accompanying drawings.
Fig. 1 is a block diagram of a receiving circuit for generating an intermediate frequency signal having the frequency characteristics independent of changes in the temperature, showing an embodiment which is not claimed;
Fig. 2 is a schematic plan view showing a surface acoustic wave apparatus illustrated in Fig. 1;
Fig. 3 is a frequency and a filter characteristic view showing the frequency characteristics of the first and second intermediate frequency signals and the filter characteristics of a filter in the receiving circuit according to Fig. 1 and 2;
Fig. 4 is a block diagram of a receiving circuit for generating an intermediate frequency signal having the frequency characteristics independent of changes in the temperature, showing an embodiment according to the present invention; and
Fig. 5 is a schematic plan view showing a surface acoustic wave apparatus illustrated in Fig. 4.

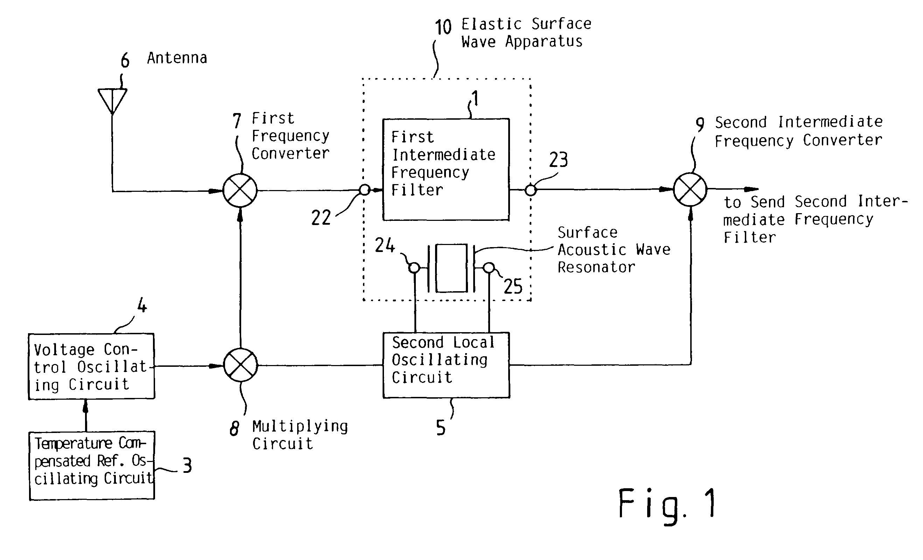

Referring to Fig. 1, an antenna 6 receives a transmission signal from a non-illustrated radio station and outputs a received signal to a first frequency converter 7. The first frequency converter 7 mixes the frequency of a first local signal output from a multiplying circuit 8 and the frequency of the received signal and outputs a first intermediate frequency signal to a first intermediate frequency filter 1.

A temperature compensated reference oscillating circuit 3 supplies a reference frequency signal which always has fixed frequency characteristics irrespective of change in the ambient temperature to a voltage controlled oscillating circuit 4. In the receiving circuit of the preferred embodiment, a phase locked loop circuit (a PLL circuit) may be provided between the temperature compensated reference oscillating circuit 3 and the voltage controlled oscillating circuit 4. The voltage controlled oscillating circuit 4 outputs a first oscillation frequency signal to the multiplying circuit 8 in response to the frequency of the reference frequency signal. Further, when a reference oscillator 3 having a high accuracy is used, the temperature compensation may be unnecessary.

The multiplying circuit 8 multiplies the first oscillation frequency signal by a second oscillation frequency signal from a second local oscillating circuit 5 and outputs a first local signal to a first frequency converting circuit 7.

The first intermediate frequency filter 1 is provided with an input terminal 22 and an output terminal 23 and constituted by a surface acoustic wave filter. The first intermediate frequency filter 1 filters the first intermediate frequency signal and outputs the thus-filtered first intermediate frequency signal to a second intermediate frequency converter 9. A surface acoustic wave resonator 2 is provided with an input terminal 24 and an output terminal 25 and connected to the second local oscillating circuit 5. The second local oscillating circuit 5 outputs a second oscillation frequency signal based on the origination oscillation of the surface acoustic wave resonator 2 to the multiplying circuit 8 and the second frequency converter 9. A surface acoustic wave apparatus 10 is constituted by the first intermediate frequency filter 1 and the surface acoustic wave resonator 2.

The second frequency converting circuit 9 mixes the frequency of the filtered first intermediate frequency signal and the frequency of the second oscillation frequency signal and outputs a second intermediate frequency signal to a second intermediate frequency filter (not shown).

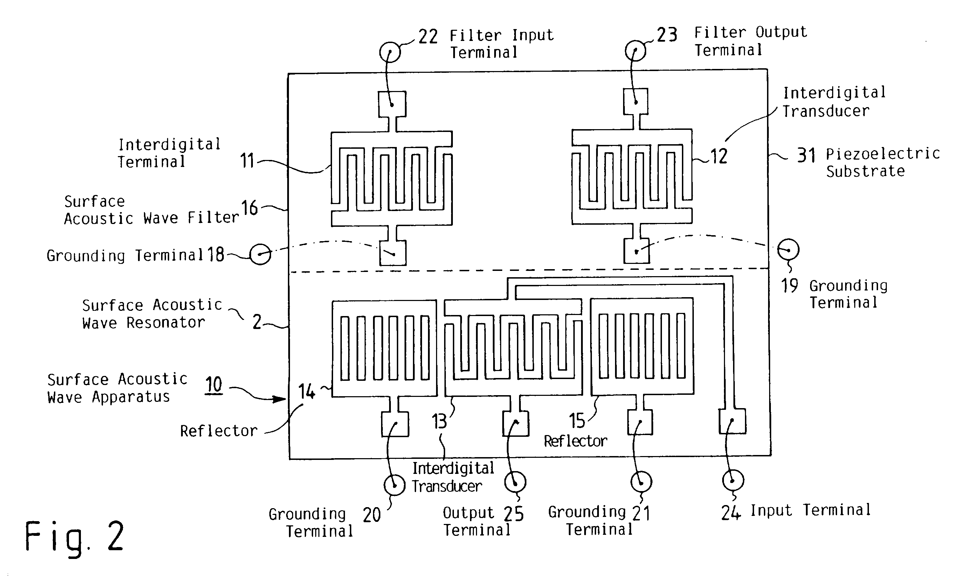

In Fig. 2, the first intermediate frequency filter 1 is constituted by a surface acoustic wave filter 16, and the surface acoustic wave filter 16 is formed on the upper portion of a piezoelectric substrate 31 while the surface acoustic wave resonator 2 is formed on the lower portion of the same 31.

The surface acoustic wave filter 16 includes a pair of inter digital transducer 11 and 12. The inter digital transducer 11 and 12 have aluminum compositions and are transversal type electrodes. The inter digital transducer 11 is connected to the filter input terminal 22 and a grounding terminal 18. The inter digital transducer 12 is connected to the filter output terminal 23 and a grounding terminal 19.

The surface acoustic wave resonator 2 is formed by a pair of reflectors 14 and 15 and an inter digital transducer 13 provided between this pair of reflectors 14 and 15. The reflectors 14 and 15 and the inter digital transducer 13 have aluminum compositions and have the electrode pitch which is the same with that of the inter digital transducer 11 and 12 of the surface acoustic wave filter 16. The reflector 14 and 15 are connected to grounding terminals 20 and 21, respectively. The inter digital transducer 13 is connected to the input and output terminals 24 and 25 of the resonator.

The operation will now be described.

The antenna 6 first receives the transmission signal from a non-illustrated radio station and supplies the received signal having a frequency fR to the first frequency converter 7.

The multiplying circuit 8 multiplies the first oscillation frequency signal having a frequency fa by the second oscillation frequency signal having a frequency fb and outputs the first local signal having a frequency (fa + fb) to the first frequency converter 7.

In the first frequency converter 7, the received signal having a frequency fR and the first local signal having the frequency (fa + fb) are subjected to the frequency mixing. Preferably, the first intermediate frequency signal whose frequency (fa + fb - fR) is obtained by subtracting the frequency fR of the received signal from the frequency (fa + fb) of the first local signal is output to the first intermediate frequency filter 1.

The first intermediate frequency filter 1 filters the first intermediate frequency signal and outputs the thus-filtered first intermediate frequency signal to the second frequency converting circuit 9.

The second frequency converting circuit 9 subjects the filtered first intermediate frequency signal having the frequency (fa + fb - fR) and the second oscillation frequency signal having a frequency fb to the frequency mixing. Preferably, the second intermediate frequency signal whose frequency (fa - fR) is obtained by subtracting the frequency fb of the second local signal from the frequency (fa + fb - fR) of the filtered first intermediate frequency signal is output to the second intermediate frequency filter (not shown).

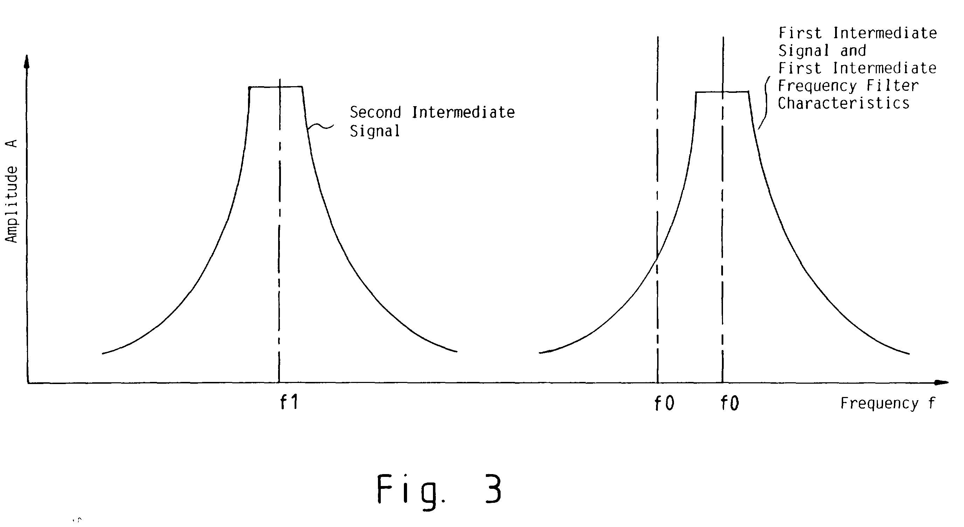

Referring to Fig. 3, when the ambient temperature changes, the center frequency of the passed frequency band in the first intermediate frequency filter 1 varies from f0 to f0'. Since the resonator characteristics of the surface acoustic wave resonator 2 responds to a change in the filter characteristics of the first intermediate frequency filter 1, the frequency of the second oscillation frequency signal varies from fb to fb'. When the first local signal varies from (fa + fb) to (fa + fb') due to a change in the frequency of the second oscillation frequency signal, the frequency of the first intermediate frequency signal varies from (fa + fb - fR) to (fa + fb' - fR). Here, there can be obtained expressions {f0 = (fa + fb - fR)} and {f0' = (fa + fb' - fR)}. The center frequency of the first intermediate frequency signal thus changes from the original center frequency f0 to the frequency f0'.

The first intermediate frequency filter 1, therefore, does not cut off any frequency which must not be essentially cut off among the frequencies of the first intermediate frequency signal.

Further, the frequency of the second intermediate frequency signal is obtained by subtracting the frequency fb of the second oscillation frequency signal from the frequency of the first intermediate frequency signal, and namely equals to fa - fR. In other words, even when the center frequency of the first intermediate frequency signal deviates from the original frequency f0 to the frequency f0', the frequency of the second intermediate frequency signal is compensated by the frequency of the second oscillation frequency signal having the same amount of deviation with that of the center frequency, and hence the center frequency f1 (= fa - fR) desired in the receiving circuit can be obtained.

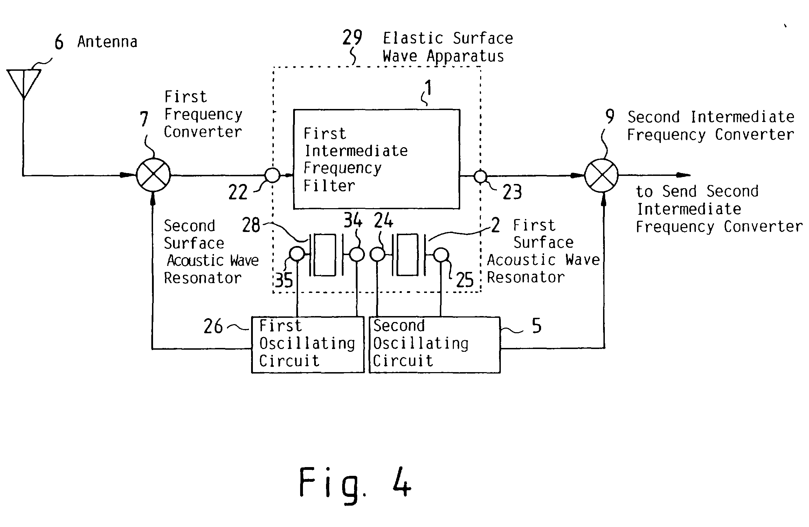

In the above-described embodiment the voltage controlled oscillating circuit 4 connected to the temperature compensated reference oscillating circuit 3 outputs the first oscillation frequency signal and the multiplying circuit 8 multiplies the first oscillation frequency signal by the second oscillation frequency signal output from the second local oscillating circuit 5 to output the first local signal. Meanwhile, in the preferred embodiment shown in Fig. 4, the first local signal is output from a first local oscillating circuit 26 which is connected to a second surface acoustic wave resonator 28 having a natural oscillation different from the natural oscillation of the surface acoustic wave resonator 2 illustrated in Fig. 1 and 2 through input and output terminals 34 and 35. The second surface acoustic wave resonator 28 is formed on the same piezoelectric substrate together with the first intermediate frequency filter 1, i.e., the surface acoustic wave filter 16, and the first and second surface acoustic wave resonators 28 and 2 and the intermediate frequency filter 1 constitute a surface acoustic wave apparatus 29.

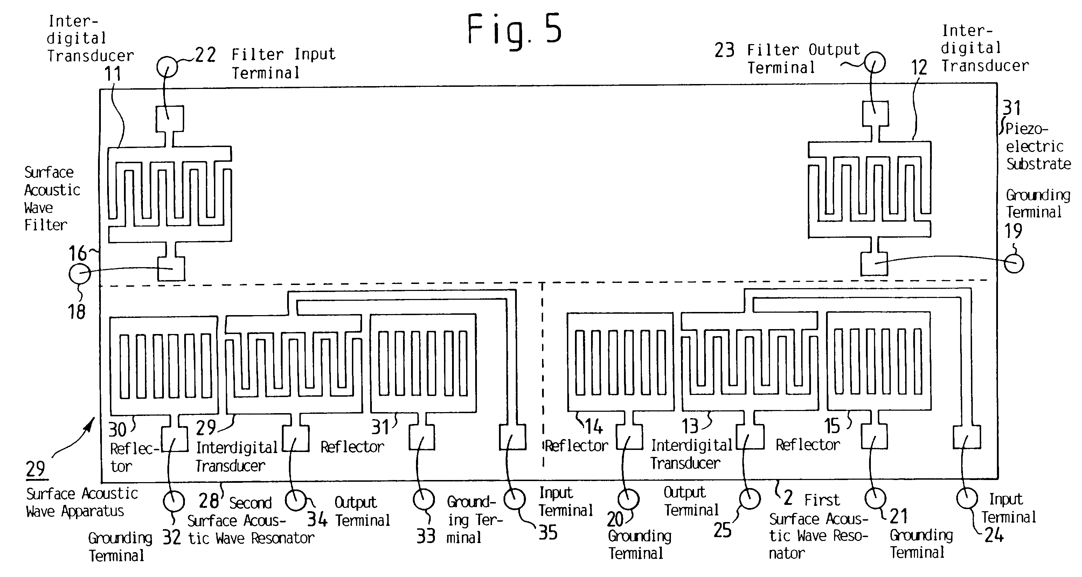

As shown in Fig. 5, the second surface acoustic wave resonator 28 adopts the same arrangement with that of the first surface acoustic wave resonator 2.

In this embodiment, the frequency characteristics of the first and second intermediate frequency signals and the filter characteristics of the filter have the same temperature characteristics with those in the above-described first embodiment, and even when the ambient temperature changes, the receiving circuit can generate the intermediate frequency signal having any desired frequency, in the similar manner to the embodiment according to Fig. 1.

As described above, in the receiving circuit for generating an intermediate frequency signal having the frequency characteristics independent of the change in the ambient temperature according to the present invention, partly since the surface acoustic wave filter constituting the first intermediate frequency filter and the surface acoustic wave resonator for generating the oscillation frequency signal which determines the frequency of the second oscillation frequency signal are formed on the same piezoelectric substrate, and partly since the first frequency converter adds the frequency of the second oscillation frequency signal and the second frequency converter subtracts the frequency of the second oscillation frequency signal, it is possible to generate the second intermediate frequency signal having a desired frequency independent of changes in the ambient temperature, thereby reducing the price of the receiver.

Obviously, numerous additional modifications and variations of the present invention are possible in light of the above teachings. It is, therefore, to be understood that within the scope of the appended claims, the invention may be practiced otherwise than as specifically described herein.

## Claims

1. A receiving circuit comprising a first resonator (28), a second resonator (2), and a first local oscillating circuit (26) connected to said first resonator (28) and outputting a first local signal, wherein said receiving circuit comprises a second local oscillating circuit (5) connected to said second resonator (2) and for outputting a second local signal, a first frequency converting circuit (7) supplied with a received signal and said first local signal and generating a first intermediate frequency signal having a frequency determined by a frequency of said first local signal, a filter (16) which is formed on the same piezoelectric substrate (31) together with said first resonator (28) and said second resonator and receives an output from said first frequency converting circuit (7), and a second frequency converting circuit (9) generating a second intermediate frequency signal, supplied with an output of said filter (16) and said second local signal, said second local signal having a frequency independent of a frequency of said first local signal.

2. A receiving circuit as claimed in claim 1, wherein said first resonator (28) and said second resonator (2) are first and second surface acoustic wave resonators, respectively, said filter means (16) is a surface acoustic wave filter, and said first and second surface acoustic wave resonators and said surface acoustic wave filter are formed on the same piezoelectric substrate (31).

3. A receiving circuit as claimed in claim 1 or 2, wherein said first intermediate frequency converting means (7) outputs said first intermediate frequency signal having a frequency obtained by subtracting at least a frequency of said received signal from a frequency of said first oscillation frequency signal.

4. A receiving circuit as claimed in any of claims 1 to 3, characterized in that said second intermediate frequency converting means outputs said second intermediate frequency signal having a frequency obtained by subtracting a frequency of said second oscillation frequency signal from a frequency of said filtered first intermediate frequency signal.

## Patentansprüche

1. Empfängerschaltung mit einem ersten Resonator (28), einem zweiten Resonator (2) und einer ersten Empfängeroszillatorschaltung (26), die mit dem ersten Resonator (28) verbunden ist und ein erstes lokales Signal ausgibt, wobei die Empfängerschaltung aufweist: eine mit dem zweiten Resonator (2) verbundene zweite Empfängeroszillatorschaltung (5) zur Ausgabe eines zweiten lokalen Signals, eine erste Frequenzumsetzerschaltung (7), die mit einem Empfangssignal und dem ersten lokalen Signal gespeist wird und ein erstes Zwischenfrequenzsignal mit einer durch die Frequenz des ersten lokalen Signals bestimmten Frequenz erzeugt, ein Filter (16), das zusammen mit dem ersten Resonator (28) und dem zweiten Resonator auf dem gleichen piezoelektrischen Substrat (31) ausgebildet ist und ein Ausgangssignal von der ersten Frequenzumsetzerschaltung (7) empfängt, und eine zweite Frequenzumsetzerschaltung (9), die mit einem Ausgangssignal des Filters (16) und dem zweiten lokalen Signal gespeist wird und ein zweites Zwischenfrequenzsignal erzeugt, wobei das zweite lokale Signal eine Frequenz aufweist, die von einer Frequenz des ersten lokalen Signals unabhängig ist.

2. Empfängerschaltung nach Anspruch 1, wobei der erste Resonator (28) bzw. der zweite Resonator (2) ein erster bzw. zweiter Oberflächenwellenresonator sind, wobei die Filtereinrichtung (16) ein Oberflächenwellenfilter ist, und wobei der erste und der zweite Oberflächenwellenresonator und das Oberflächenwellenfilter auf dem gleichen piezoelektrischen Substrat (31) ausbildet sind.

3. Empfängerschaltung nach Anspruch 1 oder 2, wobei die erste Zwischenfrequenzumsetzereinrichtung (7) das erste Zwischenfrequenzsignal mit einer Frequenz ausgibt, die man durch Subtraktion mindestens einer Frequenz des Empfangssignals von einer Frequenz des ersten Schwingungsfrequenzsignals erhält.

4. Empfängerschaltung nach einem der Ansprüche 1 bis 3, dadurch gekennzeichnet, daß die zweite Zwischenfrequenzumsetzereinrichtung das zweite Zwischenfrequenzsignal mit einer Frequenz ausgibt, die man durch Subtraktion einer Frequenz des zweiten Schwingungsfrequenzsignals von einer Frequenz des gefilterten ersten Zwischenfrequenzsignals erhält.

## Revendications

1. Circuit récepteur comprenant un premier résonateur (28), un deuxième résonateur (2) et un premier circuit oscillant local (26) connecté audit premier résonateur (28) et sortant un premier signal local, dans lequel ledit circuit récepteur comprend un deuxième circuit oscillant local (5) connecté audit deuxième résonateur (2) et sortant un deuxième signal local, un premier circuit de conversion de fréquence (7) recevant un signal reçu et ledit premier signal local et générant un premier signal de fréquence intermédiaire ayant une fréquence déterminée par une fréquence dudit premier signal local, un filtre (16) qui est formé sur le même substrat piézoélectrique (31) que ledit premier résonateur (28) et ledit deuxième résonateur et qui reçoit une sortie provenant dudit premier circuit de conversion de fréquence (7), et un deuxième circuit de conversion de fréquence (9) générant un deuxième signal de fréquence intermédiaire et recevant une sortie dudit filtre (16) et ledit deuxième signal local, ledit deuxième signal local ayant une fréquence indépendante d'une fréquence dudit premier signal local.

2. Circuit récepteur selon la revendication 1, dans lequel ledit premier résonateur (28) et ledit deuxième résonateur (2) sont des premier et deuxième résonateurs d'onde acoustique de surface, respectivement, lesdits moyens de filtrage (16) sont un filtre d'onde acoustique de surface, et lesdits premier et deuxième résonateurs d'onde acoustique de surface et ledit filtre d'onde acoustique de surface sont formés sur le même substrat piézoélectrique (31).

3. Circuit récepteur selon la revendication 1 ou 2, dans lequel lesdits premiers moyens de conversion de fréquence intermédiaire (7) sortent ledit premier signal de fréquence intermédiaire ayant une fréquence obtenue en soustrayant au moins une fréquence dudit signal reçu d'une fréquence dudit premier signal de fréquence d'oscillation.

4. Circuit récepteur selon l'une quelconque des revendications 1 à 3, caractérisé en ce que lesdits deuxièmes moyens de conversion de fréquence intermédiaire sortent ledit deuxième signal de fréquence intermédiaire ayant une fréquence obtenue en soustrayant une fréquence dudit deuxième signal de fréquence d'oscillation d'une fréquence dudit premier signal de fréquence intermédiaire filtré.
